# EUROPÄISCHE PATENTSCHRIFT

(11) **EP 1 993 133 B1**
(45) Veröffentlichungstag und Bekanntmachung des Hinweises auf die Patenterteilung: **09.05.2018**
(21) Anmeldenummer: 08008714.1
(22) Anmeldetag: 09.05.2008
(51) Int. Cl.: H01L 21/48, H01L 23/373, H05K 1/03, H05K 3/38, C04B 35/645, C04B 37/02

(54) **Verfahren zur Herstellung eines gesinterten Leistungshalbleitersubstrates**
Method for producing a sintered high performance semiconductor substrate
Procédé de fabrication d'un substrat semi-conducteur de puissance fritté

(30) Priorität: 12.05.2007 DE 102007022337
(43) Veröffentlichungstag der Anmeldung: 19.11.2008
(73) Patentinhaber: SEMIKRON Elektronik GmbH & Co. KG, 90431 Nürnberg (DE)
(72) Erfinder: Göbl, Christian, 90441 Nürnberg (DE); Braml, Heiko, Dr., 91346 Wiesenttal (DE); Hermann, Ulrich, 90408 Nürnberg (DE)

(56) Entgegenhaltungen:
- DE-A1- 3 414 065
- DE-A1- 4 233 073
- DE-A1- 10 062 108
- DE-B3-102004 019 567
- US-A- 5 807 626
- US-A1- 2003 056 981
- US-A1- 2005 205 195
- Heiko Thust ET AL: "ADVANCED LTCC PROCESSES USING PRESSURE ASSISTED SINTERING", , 10 February 2004 (2004-02-10), XP055375158, Retrieved from the Internet: URL:http://www.imaps.org/ceramics/Denver-T HUST.pdf [retrieved on 2017-05-23]

## Beschreibung

Die Erfindung beschreibt ein Leistungshalbleitersubstrat mit einem isolierenden Grundkörper und mindestens einer Leiterbahn. Derartige Leistungshalbleitersubstrate sind bisher beispielhaft bekannt als AMB- (active metal braze), beispielhaft gemäß der US 2003/0056981 A1, DCB- (direct copper bonding) oder IMS- (insulated metal substrat) Substrate.

Die mindestens eine Leiterbahn dient der elektrisch leitenden Verbindung beispielhaft mit Leistungshalbleiterbauelementen oder mit internen und/oder externen Verbindungselementen. Derartige Verbindungselemente können mit der Leiterbahn beispielhaft mittels löttechnischer Verbindungen oder mittels druckkontaktierter Verbindungen ausgebildet sein.

Gemäß dem Stand der Technik sind DCB- Substrate bekannt, die aus einem keramischen Grundkörper, häufig Aluminiumoxid oder Aluminiumnitrid, mit hierauf angeordneten Leiterbahnen aus einer Kupferfolie bestehen. Die US 4,563,383 offenbart beispielhaft die bekannten DCB- Substrate. US2005/205195 A1 beschreibt ein Verfahren zur Herstellung einer oder mehrerer Grundstrukturen auf einem LTCC Modul.

Nachteilig an derartigen DCB-, wie auch bei den AMB-, Substraten ist, dass durch den hohen Temperatureintrag während des Herstellungsprozesses das Substrat unmittelbar nach dem Herstellungsprozess oder in einen späteren Prozessschritt, beispielhaft während des Aufbaus eines Leistungshalbleitermoduls das Substrat eine Durchbiegung aufweist. Aus Versuchen bekannte Werte dieser Durchbiegung liegen hier bei ca. 1% je Längeneinheit. Je nach Verwendungszweck ist ein gewisser Grad von Durchbiegung akzeptabel, allerdings ist den meisten Anwendungen gemeinsam, dass eine möglichst geringe Durchbiegung vorteilhaft ist.

Weiterhin bekannt, beispielhaft aus der DE 42 33 073 A1 ist ein Verfahren zur Herstellung eines Leistungshalbleitermoduls mit einem der oben genannten Substrate mit einer Metalloberfläche, die mittels eines Sinterverfahrens mit einer Metallfläche eines Halbleiterbauelement verbunden wird. Hierbei weisen die jeweils zu verbindenden Kontaktflächen eine Edelmetalloberfläche auf.

Der Erfindung liegt die Aufgabe zugrunde ein Leistungshalbleitersubstrat mit geringer Durchbiegung, sowie ein einfaches und kostengünstiges Herstellungsverfahren für ein derartiges Leistungshalbleitersubstrat anzugeben.

Diese Aufgabe wird erfindungsgemäß gelöst, durch ein Leistungshalbleitersubstrat mit den Merkmalen des Anspruchs 1 hergestellt mittels eines Verfahrens nach Anspruch 5. Bevorzugte Ausführungsformen sind in den Unteransprüchen beschrieben.

Ausgangspunkt des erfindungsgemäßen Leistungshalbleitersubstrats ist ein isolierender flächiger Grundkörper. Auf mindestens einer seiner beiden Hauptflächen ist mindestens eine Schichtfolge aus einer dünnen Haftvermittelungsschicht, einer Sintermetallschicht und einer Leitungsschicht angeordnet. Hierbei bildet mindestens eine dieser Schichtfolgen eine Leiterbahn des Leistungssubstrats aus. Analog zu den bekannten, oben genannten, Substratvarianten ist es auch hier bevorzugt, wenn auf einer ersten Hauptfläche des Grundkörpers eine Mehrzahl dieser Schichtfolgen derart angeordnet sind, dass die die Leiterbahnen ausbilden und auf einer zweiten Hauptfläche eine Schichtfolge angeordnet ist und eine unstrukturierte Kontaktschicht zu einem Kühlbauteil bildet.

Hierbei ist es vorteilhaft, wenn der flächige Grundkörper eine Industriekeramik wie beispielhaft Aluminiumoxid oder Aluminiumnitrit oder Siliziumnitrit ist.

Weiterhin ist es vorteilhaft, wenn die Haftvermittelungsschicht eine Dicke zwischen 0,5µm und 10µm aufweist. Vorzugsweise weist diese Haftvermittelungsschicht noch eine beispielhaft galvanisch abgeschiedene und zur Sintermetallschicht hin gerichtete Edelmetalloberfläche auf. Die Sintermetallschicht weist vorteilhafterweise eine Dicke zwischen 5µm und 50µm auf. Hierbei ist es bevorzugt, wenn die Sintermetallschicht einen Anteil von mehr als 90 von 100 eines Edelmetalls, beispielhaft Silber, aufweist.

Weiterhin ist es bevorzugt, wenn die Leitungsschicht als eine Kupferfolie mit einer Dicke zwischen 100µm und 800µm ausgebildet ist und eine zur Sintermetallschicht hin gerichtete Edelmetalloberfläche aufweist.

Das erfindungsgemäße Verfahren zur Herstellung eines derartigen Leistungshalbleitersubstrats weist folgende wesentliche Schritte auf:
- Beschichten mindestens einer Teilfläche mindestens einer Hauptfläche des flächigen isolierenden Grundkörpers mit der Haftvermittelungsschicht.
- Anordnung einer pastösen Schicht aus dem Sintermetall und einem Lösungsmittel, auf einer Teilfläche oder auf der gesamten Fläche der Haftvermittelungsschicht.
- Anordnen der Leitungsschicht auf der Sintermetallschicht;
- Druckbeaufschlagung auf das Leistungssubstrat.

Es kann hierbei bevorzugt sein, wenn die pastöse Schicht mittels eines Schablonendruckverfahrens aufgebracht wird. Hierbei kann einerseits die notwendige Positioniergenauigkeit, bei der geforderten Schichtdicke, erreicht werden. Andererseits ist dieses Verfahren kostengünstig realisierbar.

Eine vorteilhafte Ausführung der Druckbeaufschlagung auf die pastöse Schicht kann durch die Anwendung einer Presse und zweier Pressstempel gegeben sein. Hierbei ist es zudem bevorzugt, wenn mindestens ein Pressstempel mit einem darauf angeordneten, einen quasihydrostatischen Druck erzeugenden Silikonkissen ausgebildet ist.

Hierbei ist es bevorzugt auf dem Leistungshalbleitersubstrat einer Folie, vorzugsweise eine Teflonfolie, anzuordnen und anschließend diesen Verbund mit Druck zu beaufschlagen.

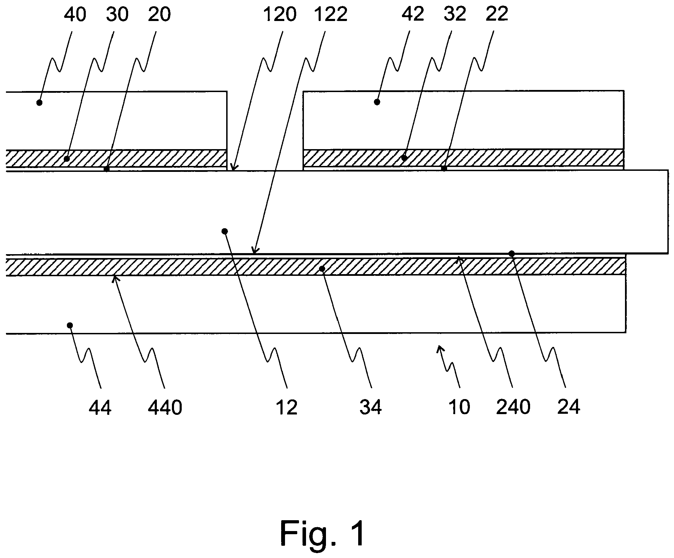

Besonders bevorzugte Weiterbildungen dieses Leistungshalbleitersubstrats sowie des Herstellungsverfahrens sind in der Beschreibung des Ausführungsbeispiels genannt. Die erfinderische Lösung wird zudem an Hand des Ausführungsbeispiels gemäß der Fig. 1 weiter erläutert.

Fig. 1 zeigt ein erfindungsgemäßes Leistungshalbleitersubstrat (10). Zudem wird hieran das erfindungsgemäße Herstellungsverfahren weiter erläutert. Das Leistungshalbleitersubstrat (10) weist einen flächig ausgebildeten isolierenden Grundkörper (12) auf. Dieser Grundkörper (12) sollte einen hohen elektrischen Widerstand bei gleichzeitig niedrigen thermischen Widerstand aufweisen, weshalb hierfür eine Industriekeramik, wie beispielhaft Aluminiumoxid oder Aluminiumnitrit oder Siliziumnitrit besonders geeignet. Einen besonders guten Kompromiss aus diesen Anforderungen und einer kostengünstigen Herstellung bietet hierbei Aluminiumoxid.

Zur Vorbereitung der folgenden Sinterverbindung wird hier auf beiden Hauptflächen (120, 122) des Grundkörpers (12) vorzugsweise ganzflächig eine dünne Schicht einer Haftvermittelungsschicht (20, 22, 24) aufgebracht, deren spezielles Herstellungsverfahren nicht Gegenstand dieser Erfindung ist. Wesentlich ist hier, dass diese Haftvermittelungsschicht (20, 22, 24) eine bevorzugte Dicke zwischen 0,5µm und 10µm aufweist. Diese Haftvermittelungsschicht (20, 22, 24) weist vorteilhafterweise einen Edelmetallanteil von mindestens 90 von 100 auf. Zusätzlich oder alternativ, bei anderer als der genannten Zusammensetzung, weist die Haftvermittelungsschicht (20, 22, 24) auf der dem Grundkörper (12) abgewandten Fläche (240) eine, beispielhaft galvanisch abgeschiedene, Edelmetalloberfläche auf.

Es kann weiterhin bevorzugt sein diese Haftvermittelungsschicht (20, 22, 24) ganzflächig auf der oder den weiter zu bearbeitenden Hauptflächen (120, 122) aufzubringen und in einem weiteren Prozessschritt gemäß der späteren Gestalt der Leiterbahnen diese Haftvermittelungsschicht (20, 22, 24) zu strukturieren.

In einem nächsten Prozessschritt wird beispielhaft mittels Schablonendrucktechnik die Sintermetallschicht (30, 32, 34) mit einer Schichtdicke zwischen 5µm und 50µm aufgebracht. Diese Sintermetallschicht (30, 32, 34) besteht zu diesem Zeitpunkt des Herstellungsprozesses aus einer pastösen Schicht des eigentlichen Sintermetalls und einem Lösungsmittel. Das Sintermetall ist hierbei ausgebildet als Metallflocken mit Ausdehnungen in der Größenordnung von Mikrometern.

Da das Lösungsmittel aus der pastösen Schicht zu mindestens 90 von 100 Anteilen wieder ausgetrieben sein sollte, bevor der Sinterprozess beginnt ist es vorteilhaft das Substrat (10) für einen geeigneten Zeitraum mit einer Temperatur zwischen 350K und 450K zu beaufschlagen.

In einem nächsten Schritt wird auf der pastösen Schicht bzw. auf der Sintermetallschicht (30, 32, 34) die Leitungsschicht (40, 42, 44) angeordnet. Hierbei handelt es sich in diesem Ausführungsbeispiel um eine Kupferfolie, die bereits gemäß der späteren Gestalt der Leiterbahnen strukturiert ist. Zur effektiven Stromleitung weist diese Leitungsschicht (40, 42, 44) eine Dicke zwischen 100µm und 800µm auf.

Zur wirkungsvollen Ausbildung der Sinterverbindung ist die Kupferfolie der Leitungsschicht (40, 42, 44) mit einer zur Sintermetallschicht hin gerichteten Edelmetalloberfläche (440) ausgebildet.

Nach der Anordnung der Leitungsschicht (40, 42, 44) auf der Sintermetallschicht (30, 32, 34) wird auf die Leitungsschicht (40, 42, 44) Druck eingeleitet. Hierbei kann es vorteilhaft sein vor der Druckbeaufschlagung eine Folie, vorzugsweise eine Teflonfolie, zwischen der Leitungsschicht (40, 42, 44) und dem Druckstempel der Druckeinrichtung anzuordnen um ein leichtes lösen hiervon nach der Druckbeaufschlagung sicher zu stellen.

Es hat sich als vorteilhaft erwiesen einen Enddruck von mehr als 8MPa aufzuwenden und gleichzeitig das Leistungssubstrat (10) auf eine Temperatur zwischen 350K und 600K zu erwärmen.

Als Alternative zu oben beschriebenen Herstellungsverfahren kann auch auf einer oder beiden Seiten des Grundkörpers je eine Schichtfolge aus Haftvermittelungsschicht, Sintermetallschicht und Leitungsschicht ganzflächig aufgebracht werden und in einem abschließenden Prozessschritt gemäß den schaltungsgerechten Vorgaben strukturiert werden. Hierfür geeignet sind naßchemische Ätztechniken.

Ein Vorteil des erfindungsgemäßen Leistungshalbleitersubstrats (10) ist es, dass durch die Sinterverbindung des Grundkörpers (12) und der Leitungsschicht (40, 42, 44) eine dauerhaft haltbare und qualitativ sehr hochwertige Verbindung ausgebildet wird. Da im Rahmen des Sinterprozesses die Temperaturbeaufschlagung vorzugsweise 600K nicht überschreitet fällt die thermisch bedingte Durchbiegung des Leistungshalbleitersubstrats (10) wesentlich geringer aus als bei Herstellungsverfahren gemäß dem Stand der Technik.

Die erfindungsgemäße Herstellung entspricht hinsichtlich der benötigten Materialien, wie auch der notwendigen Anlagen einer Drucksinterverbindung für Leistungshalbleiterbauelemente nach dem Stand der Technik. Hierdurch ist die Herstellung eines derartigen Leistungshalbleitersubstrats (10) besonders vorteilhaft, weil einfach und kostengünstig, möglich.

## Patentansprüche

1. Verfahren zur Herstellung eines Leistungshalbleitersubstrats (10) mit einem isolierenden flächigen Grundkörper (12), mit mindestens einer auf mindestens einer Hauptfläche (120, 122) angeordneten Schichtfolge aus einer dünnen Haftvermittelungsschicht (20, 22, 24), einer Sintermetallschicht (30, 32, 34) und einer Leitungsschicht (40, 42, 44) mit den wesentlichen Schritten:
• Beschichten mindestens einer Teilfläche mindestens einer Hauptfläche (120, 122) des flächigen isolierenden Grundkörpers (12) mit der Haftvermittelungsschicht (20, 22, 24);
• Anordnung einer pastösen Schicht aus dem Sintermetall und einem Lösungsmittel, auf einer Teilfläche oder auf der gesamten Fläche der Haftvermittelungsschicht (20, 22, 24), wobei die Haftvermittelungsschicht (20, 22, 24) eine Dicke zwischen 0,5µm und 10µm aufweist und eine zur Sintermetallschicht (30, 32, 34) hin gerichtete Edelmetalloberfläche (240) aufweist;
• Anordnen der Leitungsschicht (40, 42, 44) auf der Sintermetallschicht (30, 32, 34);
• Druckbeaufschlagung auf die Leitungsschicht (40, 42, 44) des Leistungssubstrats (10) wobei der maximale Enddruck bei der Druckbeaufschlagung mindestens 8MPa entspricht und wobei während der Druckbeaufschlagung das Leistungshalbleitersubstrat (10) auf eine Temperatur zwischen 350K und 600K erwärmt ist.

2. Verfahren nach Anspruch 1,
wobei der flächige Grundkörper (12) eine Industriekeramik ist.

3. Verfahren nach Anspruch 2,
wobei die Industriekeramik Aluminiumoxid oder Aluminiumnitrit oder Siliziumnitrit ist.

4. Verfahren nach Anspruch 1,
wobei die Sintermetallschicht (30, 32, 34) eine Dicke zwischen 5µm und 50µm aufweist und / oder
wobei die Leitungsschicht (40, 42, 44) ein Kupferfolie mit einer Dicke zwischen 100µm und 800µm ist und eine zur Sintermetallschicht (30, 32, 34) hin gerichtete Edelmetalloberfläche (440) aufweist.

5. Verfahren nach Anspruch 1,
wobei die pastöse Schicht mittels eines Schablonendruckverfahrens aufgebracht wird.

6. Verfahren nach Anspruch 1,
wobei der Druck mittels einer Presse und zweier Pressstempel, wobei mindestens ein Pressstempel mit einem darauf angeordneten quasihydrostatischen Druck erzeugenden Silikonkissen ausgebildet ist, aufgebracht wird.

7. Verfahren nach Anspruch 1,
wobei vor der Druckbeaufschlagung das Leistungshalbleitersubstrat (10) mit einer Folie bedeckt wird.

## Claims

1. Method for producing a performance semiconductor substrate (10) having an isolating planar main body (12), having at least one layer sequence from a thin adhesion-promotion layer (20, 22, 24), a sintered metal layer (30, 32, 34), and a conductor layer (40, 42, 44), disposed on at least one main face (120, 122), said method comprising the following substantial steps:
• coating at least one part-face of at least one main face (120, 122) of the planar isolating main body (12) with the adhesion-promotion layer (20, 22, 24);
• disposing a pasty layer from the sintered metal and a solvent on a part-face or on the entire face of the adhesion-promotion layer (20, 22, 24), wherein the adhesion-promotion layer (20, 22, 24) has a thickness between 0.5 µm and 10 pm, and has a precious-metal surface (240) that is directed towards the sintered metal layer (30, 32, 34);
• disposing the conductor layer (40, 42, 44) on the sintered metal layer (30, 32, 34);
• impinging the conductor layer (40, 42, 44) of the performance substrate (10) with pressure, wherein the maximum final pressure in the pressure impingement corresponds to at least 8 MPa, and wherein the performance semiconductor substrate (10) during the impingement with pressure is heated to a temperature between 350 K and 600 K.

2. Method according to Claim 1,
wherein the planar main body (12) is an industrial ceramic.

3. Method according to Claim 2,
wherein the industrial ceramic is aluminium oxide or aluminium nitrite or silicon nitrite.

4. Method according to Claim 1,
wherein the sintered metal layer (30, 32, 34) has a thickness between 5 µm and 50 pm, and/or wherein the conductor layer (40, 42, 44) is a copper foil which has a thickness between 100 µm and 800 µm and has a precious-metal surface (440) that is directed towards the sintered metal layer (30, 32, 34).

5. Method according to Claim 1,
wherein the pasty layer is applied by means of a screen-printing method.

6. Method according to Claim 1,
wherein the pressure is applied by means of a press and two press rams, wherein at least one press ram is configured with a silicone cushion disposed thereon that generates a quasi-hydrostatic pressure.

7. Method according to Claim 1,
wherein the performance semiconductor substrate (10) prior to the impingement by pressure is covered by a film/foil.

## Revendications

1. Procédé de fabrication d'un substrat semi-conducteur de puissance (10) comprenant un corps de base plat isolant (12), comprenant au moins une succession de couches agencée sur au moins une surface principale (120, 122), constituée par une couche mince de promoteur d'adhésion (20, 22, 24), une couche de métal fritté (30, 32, 34) et une couche de conduction (40, 42, 44), comprenant les étapes essentielles suivantes :
- le revêtement d'au moins une surface partielle d'au moins une surface principale (120, 122) du corps de base isolant plat (12) avec la couche de promoteur d'adhésion (20, 22, 24) ;
- l'agencement d'une couche pâteuse constituée par le métal fritté et un solvant sur une surface partielle ou sur la surface entière de la couche de promoteur d'adhésion (20, 22, 24), la couche de promoteur d'adhésion (20, 22, 24) présentant une épaisseur comprise entre 0,5 µm et 10 pm, et comprenant une surface en métal noble (240) orientée vers la couche de métal fritté (30, 32, 34) ;
- l'agencement de la couche de conduction (40, 42, 44) sur la couche de métal fritté (30, 32, 34) ;
- l'application de pression sur la couche de conduction (40, 42, 44) du substrat de puissance (10), la pression finale maximale lors de l'application de pression correspondant à au moins 8 MPa, et le substrat semi-conducteur de puissance (10) étant porté à une température comprise entre 350 K et 600 K pendant l'application de pression.

2. Procédé selon la revendication 1, dans lequel le corps de base plat (12) est une céramique industrielle.

3. Procédé selon la revendication 2, dans lequel la céramique industrielle est de l'oxyde d'aluminium ou du nitrite d'aluminium ou du nitrite de silicium.

4. Procédé selon la revendication 1, dans lequel la couche de métal fritté (30, 32, 34) présente une épaisseur comprise entre 5 µm et 50 pm, et/ou la couche de conduction (40, 42, 44) est une feuille en cuivre d'une épaisseur comprise entre 100 µm et 800 pm, et comprend une surface en métal noble (440) orientée vers la couche de métal fritté (30, 32, 34).

5. Procédé selon la revendication 1, dans lequel la coche pâteuse est appliquée au moyen d'un procédé d'impression au pochoir.

6. Procédé selon la revendication 1, dans lequel la pression est appliquée au moyen d'une presse et de deux poinçons, au moins un poinçon étant configuré avec un coussin de silicone agencé sur celui-ci, générant une pression quasi-hydrostatique.

7. Procédé selon la revendication 1, dans lequel le substrat semi-conducteur de puissance (10) est recouvert avec une feuille avant l'application de pression.
